(19)

Europäisches
Patentamt
European
Patent Office
Office européen
des brevets

(11) **EP 1 748 663 B1**

(12) **EUROPEAN PATENT SPECIFICATION**

(45) Date of publication and mention
of the grant of the patent:
**24.08.2011 Bulletin 2011/34**

(51) Int Cl.:
*H04W 24/06* (2009.01)

(21) Application number: **06118146.7**

(22) Date of filing: **29.07.2006**

(54) **System and method of determining standby time for a mobile station**

System und Verfahren zur Bestimmung der Standby-Zeit einer Mobilstation

Système et procédé de détermination du temps d'attente d'une station mobile

(84) Designated Contracting States:
**AT BE BG CH CY CZ DE DK EE ES FI FR GB GR
HU IE IS IT LI LT LU LV MC NL PL PT RO SE SI
SK TR**
Designated Extension States:
**AL BA HR MK RS**

(30) Priority: **29.07.2005 CA 2514164**

(43) Date of publication of application:
**31.01.2007 Bulletin 2007/05**

(60) Divisional application:
**10184983.4 / 2 270 527**

(73) Proprietor: **RESEARCH IN MOTION LIMITED**
**Waterloo, Ontario N2L 3W8 (CA)**

(72) Inventors:
• **Jin, Xin**
  **Waterloo**
  **Ontario**
  **N2L 6R4 (CA)**
• **Mallalieu, Jennifer**
  **Ottawa**
  **Ontario**
  **K2C 2L6 (CA)**
• **Shearer, Fiona**
  **Ottawa**
  **Ontario**
  **K1Y 0G9 (CA)**

(74) Representative: **Patel, Binesh et al**
**Barker Brettell LLP**
**100 Hagley Road**
**Edgbaston**
**Birmingham**
**B16 8QQ (GB)**

(56) References cited:
**EP-A2- 0 803 959      WO-A-2005/024446**

• **"Battery Life Measurement Technique" GSM
  ASSOCIATION MOU PRD, [Online] no. TW.09,
  October 1998 (1998-10), XP002403451 Retrieved
  from the Internet: URL:http:
  //www.gsmworld.com/documents/inde x.shtml>
  [retrieved on 2006-10-16]**
• **EDWARD BROREIN, AGILENT TECHNOLOGIES:
  "Using Battery Drain ANalysis to Improve Mobile-
  Device Operating Time"[Online] 19 September
  2002 (2002-09-19), XP002403452 USA Retrieved
  from the Internet: URL:www.agilent.com>
  [retrieved on 2006-10-16]**
• **K. LAHIRI ET AL.: "Efficient Power Profiling for
  Battery-Driven Embedded System Design" IEEE
  TRANS. ON COMPUTER-AIDED DESIGN OF
  INTEGRATED CIRCUITS AND SYSTEMS, [Online]
  vol. 23, no. 6, June 2004 (2004-06), XP002403453
  Retrieved from the Internet: URL:http://
  ieeexplore.ieee.org/iel5/43/289 35/01302191.pdf>
  [retrieved on 2006-10-16]**

**Description**

This patent document relates generally to testing mobile stations, and in particular to a system and method of determining standby time for mobile stations.

Mobile station battery life is usually described in terms of talk-time and standby time. Known methods of measuring standby time for mobile stations require substantial lengths of time to execute. With the proliferation of mobile station models and features, standby time determination must be repeated for each new variation, adding considerable cost to test protocols. The current method used to test standby time detailed in a standard by the CDMA Development Group (CDG 35) has an extremely long test time which is equal to its standby time, almost 10 days in some cases. The length of these tests makes it nearly impracticable to run multiple test cases.

There is a need for a mobile terminal standby test method and apparatus that reduces test times.
In 1998 agreed means for quoting battery life and current consumption for mobile stations were published in "Battery Life Measurement Technique" GSM Association MOU PRD, no. TW.09 October 1998 XP002403451. Procedures for testing battery current drain in idle and dedicated (i.e. during a call) mode are set out in this prior art document.
The state of battery life measurement in 2002 is reviewed in "Using Battery Drain Analysis to Improve Mobile Device Operating Time" by Edward Brorein, Agilent Technologies, XP002403452. Here it is recognised that test times can be reduced by determining battery life from average current drain measured for a period deemed to be representative of the overall run time. The difficulty of accurate measurement of average current is mentioned. It is suggested to use a power supply rather than the battery itself to provide a constant voltage and other elements of a test circuit are proposed to improve the accuracy of the measurement.

The patent disclosure describes a solution to one or more of the problems described above, and is defined by the appended claims.

The technology disclosed herein is preferably suited for use in Personal Digital Assistants (PDAs), mobile communication devices, cellular phones, and wireless two-way e-mail communication devices (collectively referred to herein as "mobile stations" or "mobile devices").

The term "battery capacity" is used to refer to the capacity of a battery. Typically in a mobile terminal environment it is the amount of discharge from a fully charged battery, to the mobile terminal battery cut off voltage. The battery cut off voltage is usually the voltage at which the mobile terminal shuts down or in some instance where the radio is shut off or disabled. The term "battery capacity consumed" (also known as "charge consumed" or "charge") is used to refer to the amount of discharge.

In accordance with an embodiment of the patent disclosure, there is preferably provided a simulated standby time test method that determines a standby time of a MSUT based on available battery capacity and characterization of radio shut-off voltage, receive and transmit current measurements according to claims 1, which advantageously considerably cuts down the test time. For mobile device where radio is the only function, the radio shut-off voltage is equivalent to mobile device shut-off. For some smart phones or PDAs, the radio will shut-off before the mobile device shuts off, and radio shut-off voltage should be characterized. In this document radio shut-off will be used.

In one aspect, the present invention provides a method of determining standby time for a mobile station according to claim 1.

The method preferably comprises the steps of determining a radio off battery voltage and deriving a battery capacity in dependence upon the radio off battery voltage.

The step of measuring the average current is preferably carried out at intervals shorter than the intervals between transmit activity in standby mode in a live network.

In accordance with another embodiment of the patent disclosure, there is preferably provided a system for determining standby time for a mobile station according to claim 20. The system comprises a battery simulator, a base station emulator and a computer including a module for carrying out the steps described above.

The system may comprise a module for deriving a battery capacity in dependence upon the radio off battery voltage, a module for measuring current consumption while the mobile station is in standby mode and a module for determining a standby time for the mobile station in dependence upon the battery capacity and average current consumption, where the predetermined time is less than the standby time. The system may comprise a battery simulator, a base station emulator, and a computer comprising a computer readable medium storing program code which when executed by a processor of said computer causes the system to perform a method described herein.

In accordance with another embodiment of the patent disclosure, there is preferably provided a computer readable medium storing program code according to claim 21 which when executed by a processor of a computer causes the computer to perform any of the methods described herein.

A system and method of the patent disclosure will now be described with reference to various examples of how the embodiments can best be made and used. For convenience, like reference numerals are used throughout the description and several views of the drawings to indicate like or corresponding parts, wherein the various elements are not necessarily drawn to scale. All units of measurement provided in this disclosure are by way of example only. Alternative units of measurement can be used with appropriate amendments to the calculations described herein.

BRIEF DESCRIPTION OF THE DRAWINGS

An embodiment of the patent disclosure will now be described by way of example only with reference to the following drawings in which:

Fig. 1 there is illustrated an example of a system for determining standby time, in accordance with an embodiment of the patent disclosure;

Fig. 2 there is illustrated an example of a four wire setup for a mobile station under test (MSUT) in accordance with an embodiment of the patent disclosure;

Fig. 3 graphically illustrates an example of transmit mode current measurement, in accordance with an embodiment of the system for determining standby time of the MSUT;

Fig. 4 graphically illustrates an example of receive mode current measurement in accordance with an embodiment of the system for determining standby time of the MSUT;

Fig. 5 shows in a flowchart an example of a method of determining standby time for mobile stations, in accordance with an embodiment of the patent disclosure;

Fig. 6 shows in a flowchart another example of a method of determining standby time for mobile stations, in accordance with an embodiment of the patent disclosure;

Fig. 7 shows in a flowchart another example of a method of determining standby time for mobile stations, in accordance with an embodiment of the patent disclosure;

Fig. 8 shows in an execution and variable flow diagram another example of a method of determining standby time for mobile stations, in accordance with an embodiment of the patent disclosure;

Fig. 9 shows in a flowchart an example of a method of determining the radio shut off voltage, in accordance with an embodiment of the patent disclosure;

Fig. 10 shows in a flowchart another example of the process to determine radio shut off voltage, in accordance with an embodiment of the patent disclosure;

Fig. 11 shows in a flowchart an example of a method of characterizing transmit current measurements, in accordance with an embodiment of the patent disclosure;

Fig. 12 shows in a flowchart another example of a method of characterizing transmit current measurements, in accordance with an embodiment of the patent disclosure;

Fig. 13 shows in a flowchart an example of a method of characterizing receive current measurements, in accordance with an embodiment of the patent disclosure; and

Fig. 14 shows in a flowchart another example of a method of characterizing receive current measurements, in accordance with an embodiment of the patent disclosure.

DESCRIPTION OF PREFERRED EMBODIMENTS

The patent disclosure preferably describes a solution to one or more of the problems described above.

The technology disclosed herein is preferably suited for use in Personal Digital Assistants (PDAs), mobile communication devices, cellular phones, and wireless two-way e-mail communication devices (collectively referred to herein as "mobile stations" or "mobile devices").

The term "battery capacity" is used to refer to the capacity of a battery. Typically in a mobile terminal environment it is the amount of discharge from a fully charged battery, to the mobile terminal battery cut off voltage. The battery cut off voltage is usually the voltage at which the mobile terminal shuts down or in some instance where the radio is shut off or disabled. The term "battery capacity consumed" (also known as "charge consumed" or "charge") is used to refer to the amount of discharge.

In accordance with an embodiment of the patent disclosure, there is preferably provided a simulated standby time test method that determines a standby time of a MSUT based on available battery capacity and characterization of radio shut-off voltage, receive and transmit current measurements, which advantageously considerably cuts down the test time. For mobile device where radio is the only function, the radio shut-off voltage is equivalent to mobile device shut-off. For some smart phones or PDAs, the radio will shut-off before the mobile device shuts off, and radio shut-off voltage should be characterized. In this document radio shut-off will be used.

In accordance with another embodiment of the patent disclosure, there is preferably provided a method of determining standby time for a mobile station. The method may comprise the steps of for a predetermined time, measuring battery capacity usage while the mobile station is in standby mode, and determining a standby time for the mobile station in dependence upon the battery capacity and the battery capacity usage, where the predetermined time is less than the standby time.

In accordance with another embodiment of the patent disclosure, there is preferably provided a method of determining standby time for a mobile station. The method comprises the steps of for a predetermined time, measuring average current consumption while the mobile station is in standby mode, and determining a standby time for the mobile station in dependence upon the battery capacity and the average current consumption, where the predetermined time is less than the standby time.

In accordance with another embodiment of the patent disclosure, there is preferably provided a method of determining standby time for a mobile station. The method comprises the steps of determining a radio off battery voltage, deriving a battery capacity in dependence upon the radio off battery voltage, for a predetermined time, measuring battery capacity usage while the mobile station is in standby mode, and determining a standby time for the mobile station in dependence upon the battery capacity and the battery capacity usage, where the predetermined time is less than the standby time.

In accordance with another embodiment of the patent disclosure, there is preferably provided a method of determining standby time for a mobile station. The method comprises the steps of determining a radio off battery voltage, deriving a battery capacity in dependence upon the radio off battery voltage, for a predetermined time, measuring average current consumption while the mobile station is in standby mode, and determining a standby time for the mobile station in dependence upon the battery capacity and the average current consumption, where the predetermined time is less than the standby time.

In accordance with another embodiment of the patent disclosure, there is preferably provided a system for determining standby time for a mobile station. The system comprises a battery simulator, a base station emulator and a computer including a module for determining a radio off battery voltage, a module for deriving a battery capacity in dependence upon the radio off battery voltage, a module for measuring battery capacity usage in a predetermined time while the mobile station is in standby mode and a module for determining a standby time for the mobile station in dependence upon the battery capacity and the battery capacity usage, where the predetermined time is less than the standby time.

In accordance with another embodiment of the patent disclosure, there is preferably provided a system for determining standby time for a mobile station. The system comprises a battery simulator, a base station emulator and a computer including a module for determining a radio off battery voltage, a module for deriving a battery capacity in dependence upon the radio off battery voltage, a module for measuring current consumption while the mobile station is in standby mode and a module for determining a standby time for the mobile station in dependence upon the battery capacity and average current consumption, where the predetermined time is less than the standby time.

In accordance with another embodiment of the patent disclosure, there is preferably provided a system for determining standby time for a mobile station. The system may comprise a battery simulator, a base station emulator, and a computer comprising a computer readable medium storing program code which when executed by a processor of said computer causes the system to perform a method described herein.

In accordance with another embodiment of the patent disclosure, there is preferably provided a computer readable medium storing program code which when executed by a processor of a computer causes the computer to perform any of the methods described herein.

A system and method of the patent disclosure will now be described with reference to various examples of how the embodiments can best be made and used. For convenience, like reference numerals are used throughout the description and several views of the drawings to indicate like or corresponding parts, wherein the various elements are not necessarily drawn to scale. All units of measurement provided in this disclosure are by way of example only. Alternative units of measurement can be used with appropriate amendments to the calculations described herein.

This method simulates the standby time of the MSUT. The following method describes the calculations that were used to achieve the results.

Capacity, measured in units of Ampere*hours (Ah), is a standard indication of how long a battery can last. The standby time (hours) of a MSUT can be calculated by dividing the capacity available from a fully charged battery by the capacity used in one hour (i.e., the amount of charge discharged in one hour) with the MSUT in standby.

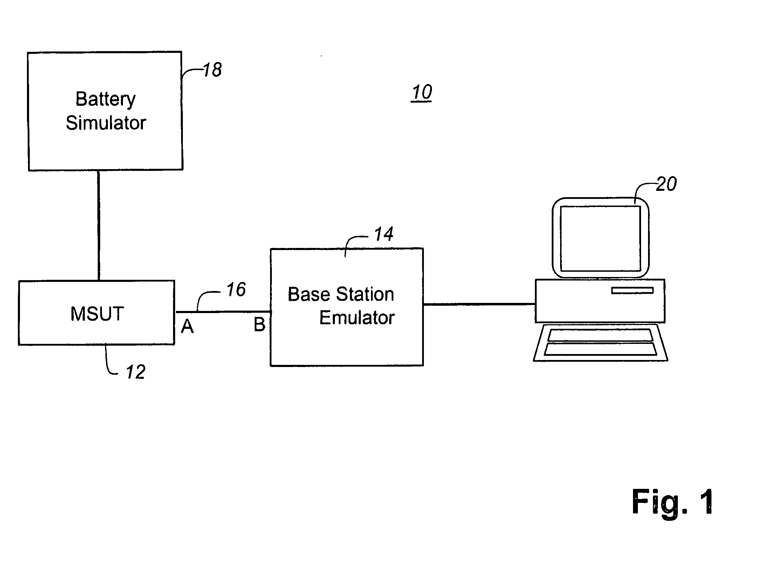

Referring to Fig. 1 there is illustrated a system 10 for determining standby time for a mobile station. Test equipment coupled to a MSUT 12 (with its battery removed) includes a base station emulator 14, for example an Agilent 8960-10 coupled via a radio frequency (RF) cable 16 to the MSUT antenna connector, a battery simulator (also known as a "battery simulator power supply", referred to as a battery simulator in this description) 18 coupled to the battery contacts of the MSUT 12, for example an Agilent 66321D, an equivalent series resistance (ESR) is programmed in the battery simulator 18 to equate to the ESR value of the battery used in the MSUT may be used (alternatively a lead having the same series resistance as the ESR of the mobile battery may be used) and a computer 20 for data collection and/or control.

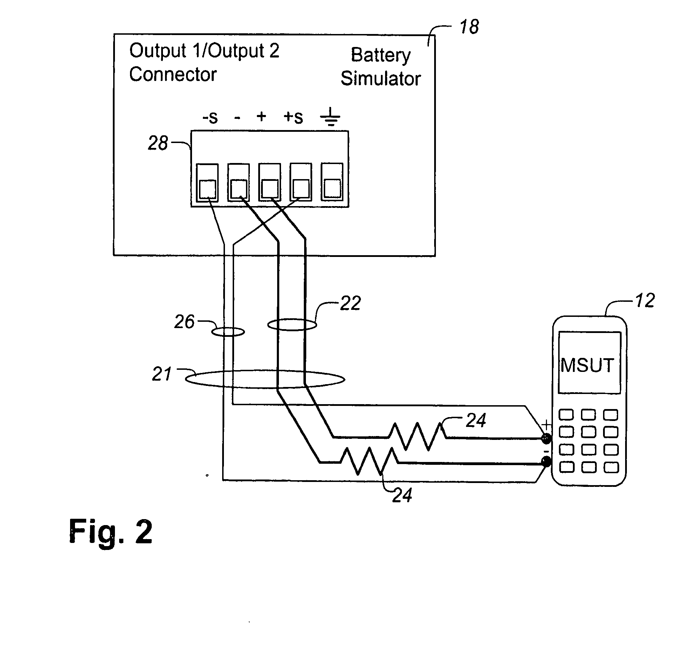

Referring to Fig. 2 there is shown a four wire setup 21 between the battery simulator 18 and the MSUT 12. The wire set up includes a pair of power lines twisted together 22, each having (undesirable) series resistance of the wire 24, and a twister pair of sense lines 26. The mobile battery is removed and the battery simulator 18 is connected using the four wire set up 21 so that the battery simulator 18 would effectively compensate for the series resistance 24. If the four wire set up 21 is not used then the external equivalent series resistance (ESR) 24 of the wires connecting to the battery simulator to the device must be accounted for in programming the battery ESR value into the battery simulator 18.

The mobile station RF insertion loss between the MSUT 12 and the wireless device tester (i.e. RF cable AB 16) is measured over a range of frequencies using a network analyzer (not shown). The insertion losses are then used in this test to correct the settings for the base station emulator 14 transmit power.

For any given battery voltage, the remaining battery capacity or charge can be determined from tables provided by the battery manufacturer as a function of unloaded voltage of the battery. (The tables can also be determined by discharging a battery with a constant known load while measuring the voltage as a variable over time.) From the tables, the capacity or charge remaining in a fully charged battery ($C_{new}$) and a discharged battery ($C_{cutoff}$) can be determined. The difference is the total battery capacity or charge available to the MSUT.

The voltage of a fully charged battery is dependent on the charger in the MSUT and also on the battery. It can be obtained by measuring the battery voltage using a voltage meter after a battery is fully charged by the charger within the MSUT. However, a cut off voltage (i.e., the voltage at which to turn off the radio by the MSUT) is determined for each individual test case by stepping down the voltage until the radio turns off. Depending on the MSUT software/hardware implementation, it may be necessary to increase the wait time between the voltage steps to ensure that the MSUT has time to update. For simplifying a test, approximations may also be made by only testing one or a few representative test conditions for the cut-off voltage, e.g., using the maximum transmit power condition in a traffic channel transmitting state, rather than testing for each individual conditions such as idle state, registration state, traffic channel transmitting state, etc. Although traffic transmitting state is not used in usual stand-by conditions, since it is easy to configure and simplifies the test, it can be used to simulate the registration condition with certain degree of accuracy. (Traffic channel and max Tx power condition can be used as a way of approximation).

There are two modes in standby: Receive and Transmit. For the most part the MSUT 12 is in Receive mode, where it waits to receive messages from the network. In this mode, the current draw is quite small. The device spends most of the time in sleep mode, and wakes up for short period of time at scheduled time slots to receive messages from base stations. In Transmit mode, the MSUT is required to transmit registration probes at regular intervals as specified by the network. This mode occurs less frequently, but draws significantly more current when in that state.

In either mode, the capacity or charge used by the MSUT 12 can be determined by measuring the current. Capacity or charge consumed is the integral of current with respect to time: $C = \int i(t)\, dt$. This can be quantized into: $C = \Sigma\, i(t) * \Delta t$. Therefore, the capacity or charge ( C ) can be determined by summing the products of current ( i(t) ) and time interval ( $\Delta t$ ) of current measurement over small intervals, i.e., taking the sum of these measured currents and multiplying the sum by the time interval ( $\Delta t$ ). The capacity or charge used by the MSUT 12 in Receive and Transmit modes is dealt with separately.

In Transmit mode, current measurements are taken for multiple transmit events to determine the total average capacity or charge used for transmitting. For the $j^{th}$ transmit event, the capacity or charge used for transmitting is $C_j$. The total time spent transmitting during that transmit event, $t_j$, is also calculated, as it is needed for calculations later on. The battery current for each transmit event is taken from the MSUT 12 as a vector of equally spaced sample data points. The sampling interval is, in one example, 4ms and a total of 4096 current measurement data points are downloaded from the battery simulator 18 for each event which form the vector. The actual transmit portion is extracted from the vector.

In a live network, the MSUT 12 may be configured for timer-based registration to transmit at intervals of 15 minutes, 30 minutes, or even longer. By using the test procedure described above in the Base Station Emulator 14 this interval can be configured to be shorter to reduce the amount of test time required to achieve a statistically significant data set of transmit events.

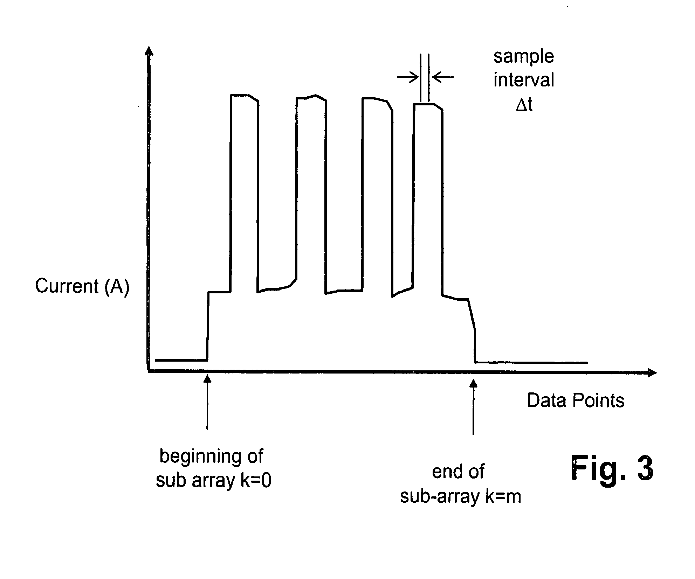

Fig. 3 illustrates an example of a current measurement during Transmit mode, where k represents the data points in the current measurement vector and where $\Delta t$ represents the sample interval between data points in the vector. The element corresponding to k=0 is the first element of the extracted sub-array for the transmit activity, and k=m the last. The beginning and the end of the sub-array is determined by finding the first and the last elements of the measured current array that has higher current value than receive current of the MSUT during "wake-up" of slotted mode operation.

The equations for the capacity or charge $C_j$ and time $t_j$ for each transmit event are shown here, where the current of the $k^{th}$ point in the measurement vector is called $i_k$:

$$C_j = \left( \sum_{k=0}^{m} ( i_k ) \right) * \Delta t;$$

and

$$t_j = m * \Delta t.$$

Using the total number of transmit events measured (N) and the number of times the MSUT registers per hour (M) in a network (where in the network, M may or may not be an integer), the total average capacity or charge used for transmitting in one hour ($C_{tx\_in\_1hr}$) and the total average time spent in one hour for transmitting ($t_{tx\_in\_1hr}$) can be determined:

$$C_{tx\_in\_1hr} = (\sum_{j=1}^{N} (C_j)) * (M / N);$$

and

$$t_{tx\_in\_1hr} = (\sum_{j=1}^{N} (t_j)) * (M / N).$$

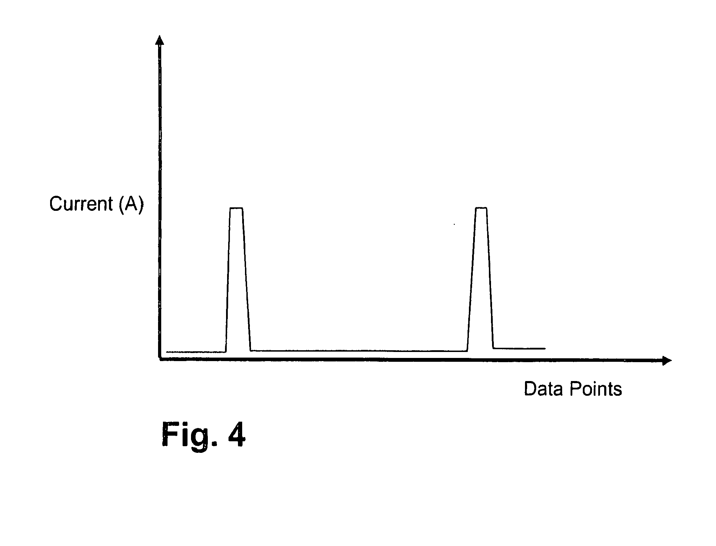

Referring to Fig. 4, illustrated is an example of a Receive Mode Current Measurement. In Receive mode (including sleep state, processor wake-up activities, and receiver wake-ups in slotted mode), the current waveform has a series of peaks that corresponds to intervals of MSUT 12 activity. The peaks of current caused by wakeups appear at known regular intervals, whereas the peaks caused by processor wake-ups can appear at variable intervals. Each receive measurement is set to capture the current for all receive states including the peaks and base levels, and takes the average current $i_{rx}$. In one example, the measurement interval is 1ms, a total of 4096 values are in each measured vector.

Since the time spent in Receive mode is simply the amount of time not spent in transmitting, using hour as the unit for time, the total capacity or charge used by the MSUT during one hour while in Receive mode can be found by:

$$C_{rx\_in\_1hr} = (i_{rx} * (1 - t_{tx\_in\_1hr})).$$

Alternatively, since the time spent in transmitting access probes for timer based registration is much smaller than the time spent in Receive mode, the $t_{tx\_in\_1hr}$ can be treated approximately as 0 in the calculation of Receive mode consumed capacity or charge.

Therefore the total capacity or charge used by the MSUT in one hour is the sum of the capacity used in both the Receive and Transmit modes:

$$C_{1hr} = C_{rx\_in\_1hr} + C_{tx\_in\_1hr}.$$

The tests may be conducted at different supply voltages and make an average if $C_{1hr}$ is dependent of voltage for improved accuracy.

After determining the available battery capacity, ($C_{new}$ - $C_{cutoff}$), and the total capacity or charge used by the MSUT in one hour, $C_{1hr}$, the Standby Time ($T_{standby}$ measured in days) can be determined by:

$$T_{standby} = (C_{new} - C_{cutoff}) / (C_{1hr} * 24 \text{ hrs/day}).$$

This test method significantly reduces the time required to complete the standby time test cases. Each test can be completed in a matter of hours, instead of days or even weeks.

Alternatively, stand-by time can be calculated using average current instead of consumed capacity (or charge) per hour. In fact, since the quantity current is defined as charge per unit time, charge per hour is also in a dimension of current. Therefore, the only difference is the unit: Amperes (i.e., Coulombs/sec) for the former, and Coulombs/3600sec for the latter. The terms capacity used in a given time duration, charge consumed in a given time duration, and current consumption are used interchangeably in this disclosure.

The alternative formula for using average current to compute the average transmit capacity or charge consumed by a registration event is:

$$C_{tx} = 1/N \sum_{j=1}^{N} (C_j).$$

The alternative formula for using average current to compute the average transmit current is:

$$i_{tx} = C_{tx} / T_{tx}, \text{ where } T_{tx} \text{ is registration interval.}$$

where $T_{tx}$ is registration interval.

The alternative formula for using average current to compute the average receive current is:

$$i_{rx} = 1/T \sum_{t=0}^{T} i(t) * \Delta t,$$

where T is the current measurement interval.

The alternative formula for using average current to compute the stand-by time is:

$$T_{standby} = (C_{new} - C_{cutoff}) / (i_{tx} + i_{rx}).$$

Standby time is the length of time the mobile station under test (MSUT) 12 can operate in standby mode using its internal battery power.

One embodiment of the test setup is provided herein below for CDMA mobile terminals.

Set the Base Station Emulator according to the test specification. The following shows one example:

- Access parameters:

  - Nominal Power: 0
  - Nominal Power Extended: 0
  - Initial Power: 0
  - Power Step: 3
  - Number of Steps: 5
  - Max Response Sequence: 2
  - Max Request Sequence: 2
  - Preamble Size: 3

- RSSI = -75 dBm and Pilot Ec/Io = -7 dBm
- The Base Station Emulator also has the following default settings:

  - o SEARCH WIN_A = 8
  - o SEARCH WIN_N = 8
  - o SEARCH WIN_R = 8
  - o Neighbor list includes 7 PN's

- The Slot Cycle Index in the MSUT can be set to 2 and the Max Slot Cycle Index in the base station emulator is set to either 1 or 2 or other values depending on the test case.
- If the test case requires QPCH be set to ON, then the QPCH level is set to -3 dB relative to pilot.
- Configuration Change Indicator (CC1) is Off

Deactivate any radio activities other than idle mode operation, and deactivate any unnecessary applications.
For each Band Class in which the MSUT operates, test the following scenarios using the above specified settings:

- Timer Based Registration Period = 15 minutes, QPCH ON (SCI=1 & SCI=2)
- Timer Based Registration Period = 15 minutes, QPCH OFF (SCI=1 & SCI=2)
- Timer Based Registration Period = 30 minutes, QPCH ON (SCI=1 & SCI=2)
- Timer Based Registration Period = 30 minutes, QPCH OFF (SCI=1 & SCI=2)

A test procedure was developed to calculate the standby time based on radio shut-off voltage measurements, the total battery capacity between the fully charged battery voltage and the measured radio shut-off voltage, and multiple current measurements during receive and transmit. The time taken to run a standby time test using this method is considerably shorter than measuring the actual standby time of the device with a battery.
The standby time test procedure comprises four major parts:

1) Determining the battery voltage at which the radio turns off and determine available capacity of the battery;
2) Characterizing transmit current measurements (CDMA registration);
3) Characterizing receive current measurements; and
4) Calculating the standby time of the MSUT.

Setup equipment and MSUT as shown in Figs. 1 and 2 and wait for the MSUT to go into idle mode.

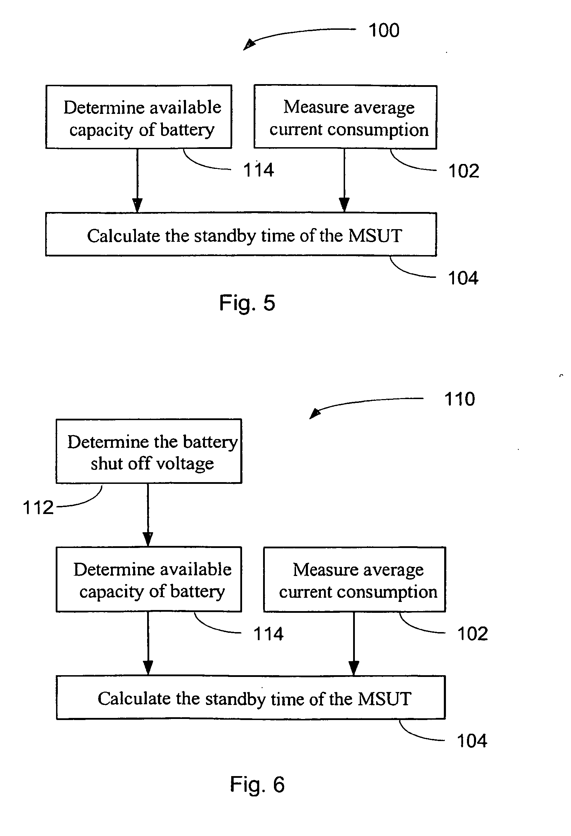

Fig. 5 shows in a flowchart an example of a method of determining standby time for mobile stations (100), in accordance with an embodiment of the patent disclosure. The method (100) comprises the steps of measuring average current consumption (102) and determining the available battery capacity (114). Next, the standby time of the MSUT is calculated (104) based upon the available battery capacity and measured average current consumption. Other steps may be added to the method (100).
Fig. 6 shows in a flowchart another example of a method of determining standby time for mobile stations (110), in accordance with an embodiment of the patent disclosure. The method (110) comprises the steps of determining the battery voltage at which the radio turns off (112) and determining the available capacity of the battery (114). Next the average current consumption is measured (102) and the standby time of the MSUT is calculated (104). Other steps may be added to the method (100).

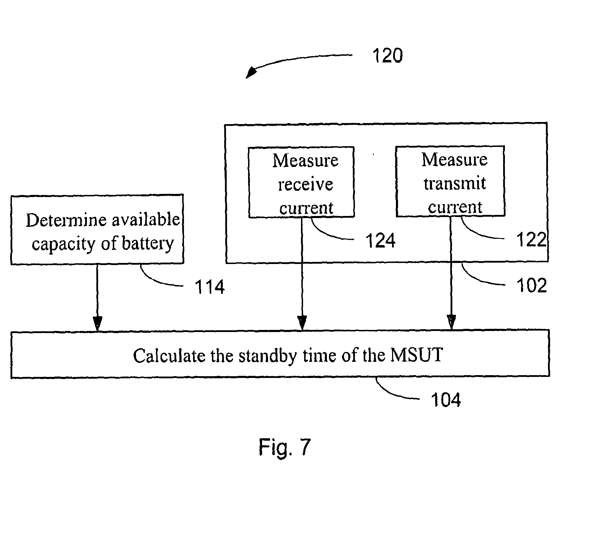

Fig. 7 shows in a flowchart another example of a method of determining standby time for mobile stations (120), in accordance with an embodiment of the patent disclosure. The method (120) comprises the steps of determining the available capacity of the battery (114), measuring transmit current (CDMA registration) (122) and measuring receive transmit current (124). Next the standby time of the MSUT is calculated (104). Other steps may be added to the method (100).

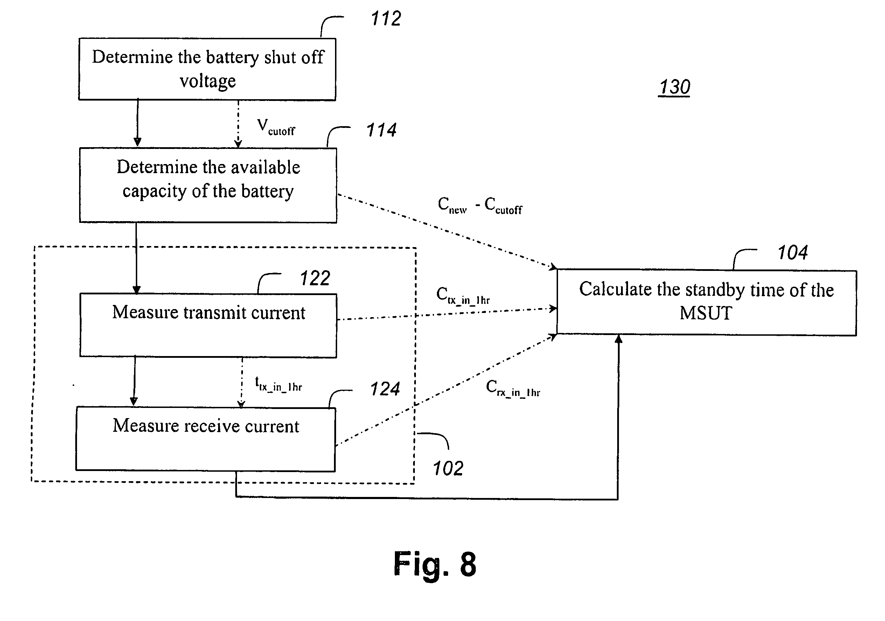

Fig. 8 shows in an execution and variable flow diagram another example of a method of determining standby time for mobile stations (130), in accordance with an embodiment of the patent disclosure. The method (130) comprises the steps of determining the battery voltage at which the radio turns off ($V_{cutoff}$) (112) and determining the available capacity of the battery (114). Next, transmit current is measured (CDMA registration) (122). Next, receive current is measured (124). The transmit current time measurement $t_{tx\_in\_1hr}$ was calculated in step (122). Finally, the standby time of the MSUT is calculated (104). For the last step (104), the available capacity $C_{new} - C_{cutoff}$ was calculated in step (114), the transmit current capacity measurement $C_{tx\_in\_1hr}$ was calculated in step (122) and the receive current measurement $C_{rx\_in\_1hr}$ was calculated in step (124). Alternatively, if the available capacity and/or the transmit current capacity measurements are known, these may be provided to a module that executes the final step (104).

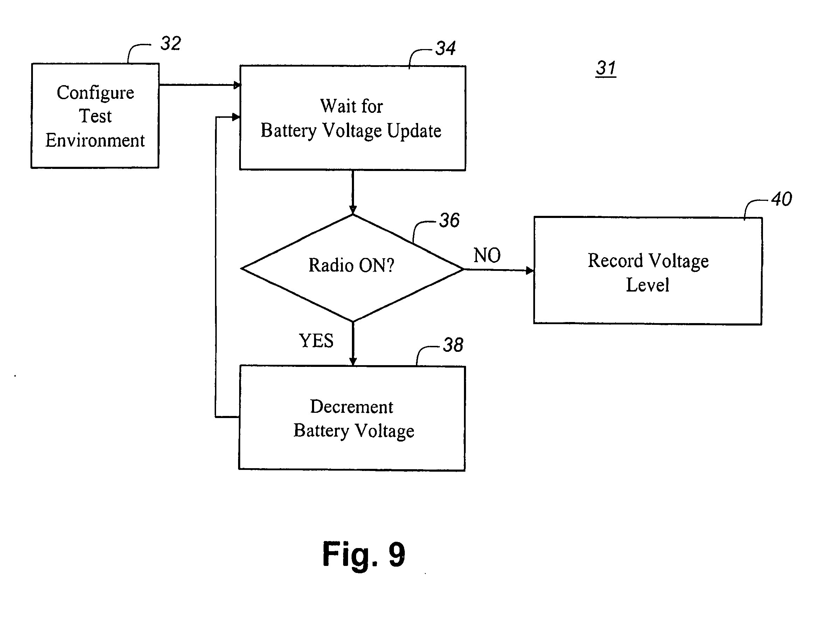

Fig. 9 shows in a flowchart an example of a method of determining the radio shut off voltage (31), in accordance with an embodiment of the patent disclosure. The method (31) begins with configuring a test environment by setting up a mobile to be set to desired working conditions (32). Next, wait the sufficient time needed for the MSUT software/hardware to update the battery voltage internally (34). If the ratio is still on (36), then decrement the battery voltage (38) and return to step (34). Otherwise (36), record the voltage level at which the radio turned off (40). Other steps may be added to this method (31).

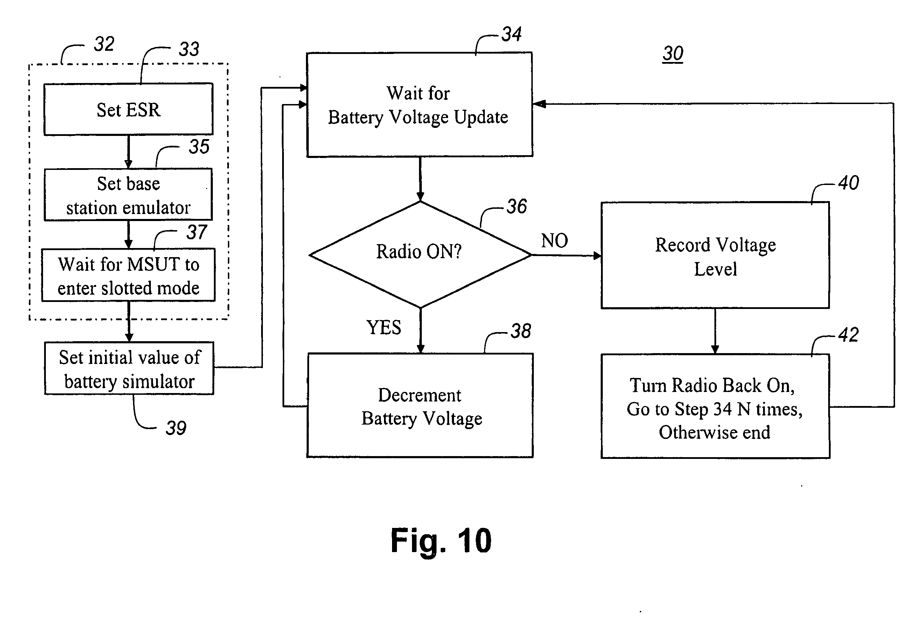

Fig. 10 shows in a flow chart another example of the process to determine radio shut off voltage (30), in accordance with an embodiment of the patent disclosure. The process (30) comprises generally of the following steps:

1) Program the battery simulator to simulate the ESR of the battery using 4-wire setup (33).
2) Set the base station emulator to transmit at desired level in accordance to test specification, and set all other parameters in accordance to test specification (35).
3) Wait for the MSUT to acquire the signal from the base station emulator, and enter the slotted mode of operation (37).
4) Program the battery simulator unloaded voltage to a small quantity (for example, 0.2 V) above the expected radio shut-off voltage, to initiate test (39).

5) Wait sufficient time needed for the MSUT software/hardware to update the battery voltage internally (34).

6) Query to see if the radio is still on (36). (This can be accomplished by trying to force a registration of the MSUT with the base station emulator).

7) Step the battery voltage down by a small quantity (for example, O.O1V) (38).

8) Repeat steps 5 thru 7 until radio turns off.

9) Record the voltage level at which radio turns off (40).

10) Program the battery simulator unloaded voltage to a small quantity (for example, 0.2 V) above the expected radio shut-off voltage, turn the radio back on, and repeat steps 5 thru 9 a number of times to get a reliable average value of radio shut-off voltage (42).

Once the radio off voltage has been determined, the available capacity of the battery to be used in the standby time calculations is calculated. To do this, the battery capacity vs. unloaded voltage profile table is characterized.

To characterize the transmit current measurements (122), the base station emulator is set with the timer based registration to "on" and the base station emulator is programmed to have the MSUT 12 register periodically (preferably shorter than the actual registration interval when used in a CDMA network, for example, every 12.1 to 30 seconds), disabling all other types of registrations except power up registration, and set the base station emulator output power to the values as defined in the test specification (e.g., - 75 dBm) with path loss accounted for. The setting to have MSUT 12 register every 12.1 to 30 seconds is not related to the network configuration under which the standby time to be tested and is used only to reduce test time.

Using the battery simulator 18, the output voltage is set to a desired value, e.g., the nominal battery voltage, and a sampling interval and array size are selected which will have a long enough window to be able to extract the sub-array of the measured battery current to cover the entire transmit activity from start of the transmitter warm-up for the registration to its end (e.g., download 4096 data points from battery simulator 66321D at sampling interval of 4 ms will ensure a window large enough to capture transmit and back to receive). The battery simulator can buffer pre-trigger current measurement data points, which will ensure capturing current data prior to the triggering point and covers a time span from receive to transmit back to receive modes. See Figure 3 as an example.

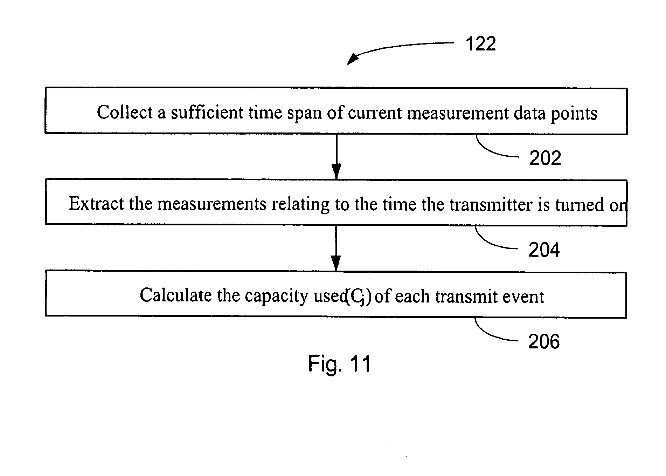

Fig. 11 shows in a flowchart an example of a method of measuring transmit current (122), in accordance with an embodiment of the patent disclosure. The method (122) comprises the steps of collecting a sufficient time span of current measurement data points (202). Next, the measurements relating to the time the transmitter is turned on are extracted (204). Finally, the capacity used ($C_j$) and time duration ($t_j$) of each transmit event are calculated (206). Other steps may be added to this method (122).

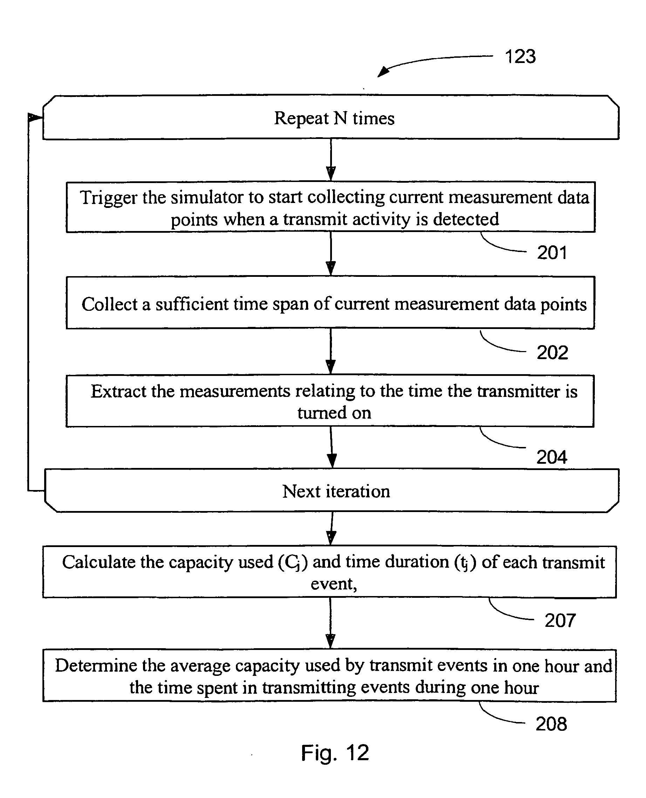

Fig. 12 shows in a flowchart another example of a method of measuring transmit current (123) using the battery simulator 18, in accordance with an embodiment of the patent disclosure. The method (123) comprises generally of the following steps:

1) Trigger the simulator to start collecting current measurement data points when a transmit activity is detected (201) (e.g., by a threshold set for current level exceeding the current consumption level for receiver only operation, such as 250 mA).

2) Collect the sufficient time span of current measurement data points from battery simulator (202) (66321D will be able to download an array of 4096 data points).

3) Extract, from the data array, the sub-array for the portion of time the transmitter is turned on (204).

4) Knowing the current at each data point in the sub-array extracted, allows the calculation of the capacity used ($C_j$) and time duration ($t_j$) of each transmit event (206):

$$C_j = \left( \sum_{k=0}^{m} \ (i_k) \right) * \Delta t;$$

and

$$t_j = m * \Delta t,$$

where k=0 is the first point of the transmit activity, m is the last point of the transmit activity, and $\Delta t$ is the sample interval.

5) Repeat 1) through 5) to record N transmit measurements (desirably N >100).

6) Determine the average capacity used by transmit events in one hour ($C_{tx\_in\_1hr}$), and the time spent in transmitting events during one hour ($t_{tx\_in\_1hr}$) (208).

$$C_{tx\_in\_1hr} = \left( \sum_{j=1}^{N} (C_j) \right) * (M / N);$$

and

$$t_{tx\_in\_1hr} = \left( \sum_{j=1}^{N} (t_j) \right) * (M / N),$$

where N is the total number of transmit events measured; and
where M is the number of registrations per hour based on network registration period configuration for which the standby time needs to be determined (M may not be an integer).

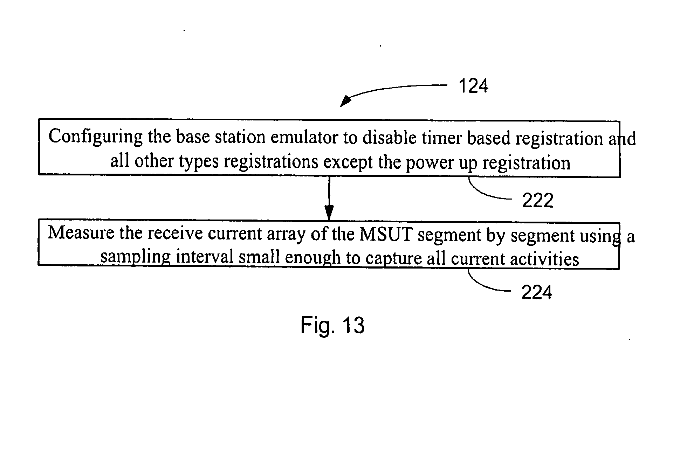

Fig. 13 shows in a flowchart an example of a method of measuring receive current (124), in accordance with an embodiment of the patent disclosure. The method (124) begins with configuring the base station emulator to disable timer based registration and all other types registrations except the power up registration (222). Next, the receive current array of the MSUT is measured segment by segment using a sampling interval small enough to capture all current activities (224). Preferably, this sampling interval is no larger than 1ms. Other steps may be added to this method (124).

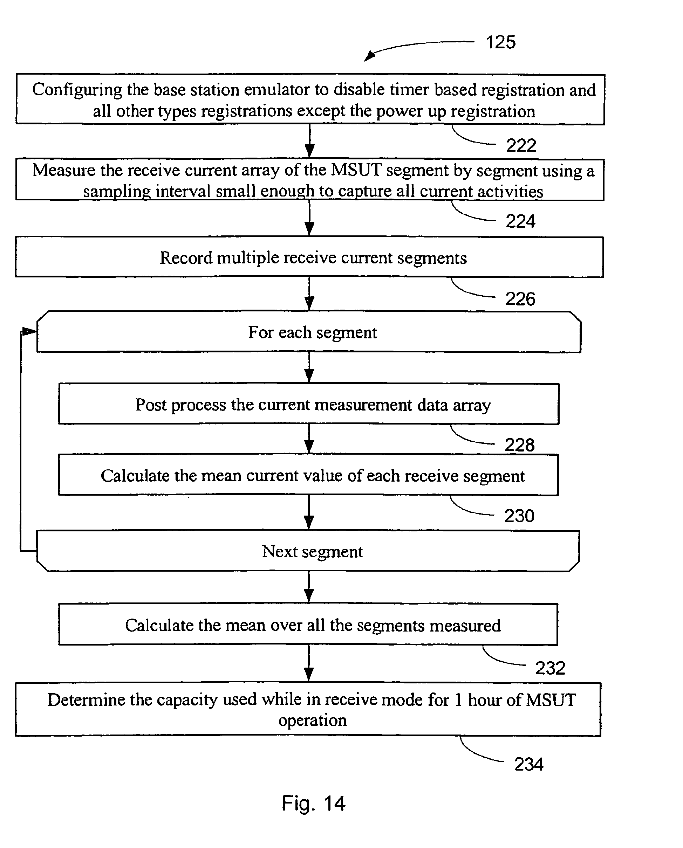

Figure 14 shows in a flowchart another example of a method of measuring receive current (125), in accordance with an embodiment of the patent disclosure. The following receive current measurements are performed for each test condition being tested (such as SCI values, quick paging settings). Again, using the battery simulator,

1) Configure the base station emulator to disable timer based registration and all other types registrations except the power up registration (222).
2) Measure the receive current array of MSUT segment by segment using a sampling interval small enough to capture all current activities (224).
Preferably, this sampling interval is no larger than 1ms.
3) Record multiple receive current segments (226) (e.g., greater than 100).
4) For each segment, post process the current measurement data array (228), calculate the mean current value of each receive segment (230), and further calculate the mean over all the segments measured (232), denote it $i_{rx}$.
5) Determine the capacity used while in receive mode for 1 hour of MSUT operation (234):
In 1 hour operation, the amount of time spent in receive mode is simply the amount of time the MSUT is not in transmit mode, which is (1 - $t_{tx\_in\_1hr}$) hour, thus the capacity used for 1 hour by receive mode:

$$C_{rx\_in\_1hr} = (i_{rx} * (1 - t_{tx\_in\_1hr})).$$

The capacity used in one hour for both transmit and receive activities is known, thus the total capacity used by the MSUT in one hour is:

$$C_{1hr} = C_{rx\_in\_1hr} + C_{tx\_in\_1hr}.$$

Using the available battery capacity determined as described previously, the standby time in hours can then be determined (104) by:

$$T_{standby} = (C_{new} - C_{cutoff}) / (C_{1hr}).$$

The system and methods according to the present disclosure may be implemented by any hardware, software or a combination of hardware and software having the above described functions. The software code, either in its entirety or a part thereof, may be stored in a computer readable memory. Further, a computer data signal representing the software code which may be embedded in a carrier wave may be transmitted via a communication network. Such a computer readable memory and a computer data signal are also within the scope of the present disclosure, as well as the hardware, software and the combination thereof.

While particular embodiments of the patent disclosure have been shown and described, changes and modifications may be made to such embodiments without departing from the scope of the patent disclosure as defined by the appended claims.

**Claims**

1. A method of determining standby time for a mobile station (12), the method comprising:

   measuring an average current consumption (102) while the mobile station is in standby mode, said standby mode including a transmit mode and a receive mode; said average current consumption being measured in both the transmit mode and the receive mode; the measuring the average current consumption comprising measuring a first plurality of current measurement data points in a transmit event in the transmit mode, and measuring a second plurality of current measurement data points in
   a receive segment in the receive mode;
   determining an available battery capacity (114) of a battery in the mobile station; and
   determining a standby time (104) for the mobile station in dependence upon the available battery capacity and the average current consumption,
   wherein the measuring the average current consumption is performed over an amount of time less than the standby time.

2. The method as claimed in claim 1, wherein the second plurality of current measurement data points are measured in a plurality of measurement intervals.

3. The method as claimed in claim 1, wherein the measuring the average current consumption is carried out at intervals shorter than the intervals between transmit modes in standby mode in a live network.

4. The method as claimed in claim 1, wherein the available battery capacity is determined based upon a radio off battery voltage (40).

5. The method as claimed in claim 1, further comprising determining a radio off battery voltage, the available battery capacity determined based upon a radio off battery voltage (40).

6. The method as claimed in claim 5, wherein determining a radio off battery voltage comprises:

   providing a simulated battery voltage (39) at a first voltage value to the mobile station (12);
   determining if the mobile station radio is on (36);
   if the mobile station radio is on, decrementing the first voltage value to a next voltage value by a predetermined amount (38), and repeating the determining if the mobile station radio is on step;
   if the mobile station radio is off, recording the radio off battery voltage.

7. The method as claimed in claim 6, wherein the determining a radio off battery voltage is repeated a plurality of times and the resulting voltage value is averaged to determine the radio off battery voltage.

8. The method as claimed in claim 7, further comprising simulating the equivalent series resistance 'ESR' effect of the battery while determining the radio off battery voltage.

9. The method as claimed in claim 1, further comprising extracting the current measurement data points of the transmit event relating to the time the transmitter is turned on (204).

10. The method as claimed in claim 9, further comprising the calculating the capacity used of each of the plurality of transmit events.

11. The method as claimed in claim 10, further comprising calculating an average capacity usage in each of the plurality of transmit events ($C_{tx}$) as:

$$C_{tx} = \left( \sum_{j=1}^{N} (C_j) \right) / N,$$

where N is a total number of transmit events measured; and calculating the average transmit current ($i_{tx}$) as:

$$i_{tx} = C_{tx} / T_{tx}$$

where $T_{tx}$ is a registration interval.

**12.** The method as claimed in claim 1, wherein the measuring average current consumption further comprises triggering the simulator to start collecting current measurement data points (201) when a transmit activity is detected and wherein the triggering comprises setting a threshold for current level exceeding the current consumption level for receiver only operation.

**13.** The method as claimed in claim 1, further comprising determining receive capacity usage, the determining receive capacity usage comprising :

configuring the base station emulator to disable timer based registration and all other types registrations except the power up registration; and
measuring the receive current array of the mobile station segment by segment using a sampling interval small enough to capture all current activities.

**14.** The method as claimed in claim 13, wherein the determining receive capacity usage further comprises:

recording multiple receive current segments (226);
for each segment:

post processing the current measurement data array (228); and
calculating the mean current value of each receive segment (230);

calculating the mean ($i_{rx}$) over all the segments measured (232); and
determining the capacity used while in receive mode for one hour of the mobile station operation (234).

**15.** The method as claimed in claim 14, wherein the capacity used for one hour by receive mode ($C_{rx\_jn\_1hr}$) is calculated by:

$$C_{rx\_in\_1hr} = (i_{rx} * (1 - t_{tx\_in\_1hr}))$$

where

$$t_{tx\_in\_1hr} = \left( \sum_{j=1}^{N} (t_j) \right) * (M / N);$$

$$t_j = m * \Delta t;$$

m is the last point of transmit activity; and $\Delta t$ is a sampling interval;

the total capacity used by the mobile station in one hour is:

$$C_{1hr} = C_{rx\_in\_1hr} + C_{tx\_in\_1hr;}$$

and the standby time in hours is calculated to be:

$$T_{standby} = (C_{new} - C_{cutoff}) / (C_{1hr})$$

where $C_{new} - C_{cutoff}$ is the capacity difference between a fully charged battery and the capacity at a cutoff voltage.

**16.** The method as claimed in claim 14, capacity used for one hour by receive mode ($C_{rx\_in\_1hr}$) is calculated by:

$$C_{rx\_in\_1hr} = (i_{rx} * 1hr).$$

**17.** The method as claimed in claim 1, further comprising determining average receive current, the determining average receive current comprising:

configuring the base station emulator to disable timer based registration and all other types registrations except the power up registration; and
measuring the receive current array of the mobile station segment by segment using a sampling interval small enough to capture all current activities.

**18.** The method as claimed in claim 17, wherein the determining average receive current further comprises:

record multiple receive current segments;
for each segment:

post processing the current measurement data array; and
calculating the mean current value of each receive segment; and calculating the mean ($i_{rx}$) over all the segments measured.

**19.** The method as claimed in claim 18, wherein the standby time in hours is calculated to be:

$$T_{standby} = (C_{new} - C_{cutoff}) / (i_{tx} + i_{rx})$$

where $C_{new}-C_{cutoff}$ is the capacity difference between a fully charged battery and the capacity at the cutoff voltage, and $i_{tx} + i_{rx}$ is the total of the average transmit current and average receive current.

**20.** A system for determining standby time for a mobile station, the system comprising:

a battery simulator (18);
a base station emulator (14); and
a computer (20) comprising a computer readable medium storing program code which when executed by a processor of said computer causes the system to perform the method of any one of claims 1 to 19.

**21.** A computer readable medium storing program code which when executed by a processor of a computer causes the computer to perform the method of any one of claims 1 to 19.

**Patentansprüche**

1. Verfahren zum Bestimmen einer Bereitschaftszeit für eine Mobilstation (12), wobei das Verfahren aufweist:

Messen eines durchschnittlichen Stromverbrauchs (102), während die Mobilstation in einem Bereitschaftsmodus ist, wobei der Bereitschaftsmodus einen Sendemodus und einen Empfangsmodus enthält, wobei der durchschnittliche Stromverbrauch sowohl im Sendemodus als auch im Empfangsmodus gemessen wird, wobei das Messen des durchschnittlichen Stromverbrauchs aufweist,
Messen einer ersten Vielzahl an Strommessungsdatenpunkten in einem Sendeereignis im Sendemodus und Messen einer zweiten Vielzahl an Strommessungsdatenpunkten in einem Empfangssegment im Empfangsmodus,
Bestimmen einer verfügbaren Batteriekapazität (114) einer Batterie in der Mobilstation und
Bestimmen einer Bereitschaftszeit (104) für die Mobilstation in Abhängigkeit von verfügbarer Batteriekapazität und dem durchschnittlichen Stromverbrauch,
wobei das Messen des durchschnittlichen Stromverbrauchs über eine Menge an Zeit durchgeführt wird, die weniger als die Bereitschaftszeit ist.

2. Verfahren nach Anspruch 1, wobei die zweite Vielzahl an Strommessungsdatenpunkten in einer Vielzahl an Messintervallen gemessen wird.

3. Verfahren nach Anspruch 1, wobei das Messen des durchschnittlichen Stromverbrauchs an Intervallen ausgeführt wird, die kürzer als die Intervalle zwischen Sendemoden im Bereitschaftsmodus in einem aktiven Netz ist.

4. Verfahren nach Anspruch 1, wobei die verfügbare Batteriekapazität auf Grundlage einer Funk-aus-Batteriespannung (40) festgestellt wird.

5. Verfahren nach Anspruch 1, ferner mit einem Bestimmen einer Funk-aus-Batteriespannung, wobei die verfügbare Batteriekapazität auf Grundlage einer Funk-aus-Batteriespannung (40) bestimmt wird.

6. Verfahren nach Anspruch 5, wobei ein Bestimmen einer Funk-aus-Batteriespannung aufweist,
Liefern einer simulierten Batteriespannung (39) mit einem ersten Spannungswert zur Mobilstation (12),
Bestimmen, ob die der Mobilstationsfunk angeschaltet (36) ist,
wenn der Mobilstationsfunk angeschaltet ist, Herabsetzen des ersten Spannungswertes auf einen nächsten Spannungswert um eine vorbestimmte Menge (38) und Wiederholen des Schritts Bestimmen, ob der Mobilstationsfunk angeschaltet ist,
wenn der Mobilstationsfunk ausgeschaltet ist, Aufnehmen der Funk-aus-Batteriespannung.

7. Verfahren nach Anspruch 6, wobei das Bestimmen einer Funk-aus-Batteriespannung eine Vielzahl an Malen wiederholt wird und der resultierende Spannungswert gemittelt wird, um die Funk-aus-Batteriespannung zu bestimmen.

8. Verfahren nach Anspruch 7, ferner mit Simulieren des Äquivalentserienwiderstand, ESR, -Effekts der Batterie während des Bestimmens der Funk-aus-Batteriespannung.

9. Verfahren nach Anspruch 1, ferner mit Extrahieren der Strommessungsdatenpunkte des Sendeereignisses bezüglich der Zeit, zu welcher der Sender angeschaltet ist (204).

10. Verfahren nach Anspruch 9, ferner mit dem Berechnen der verwendeten Kapazität jedes der Vielzahl an Sendeereignissen.

11. Verfahren nach Anspruch 10, ferner mit einem Berechnen einer durchschnittlichen Kapazitätsverwendung in jedem der Vielzahl an Sendeereignissen ($C_{tx}$) als:

$$C_{tx} = \left( \sum_{j=1}^{N} \left( C_j \right) \right) / N \, ,$$

wobei N eine Gesamtanzahl an gemessenen Sendeereignissen ist, und
einem Berechnen des durchschnittlichen Sendestroms ($i_{tx}$) als:

$$i_{tx} = C_{tx} / T_{tx}$$

wobei $T_{tx}$ ein Registrierintervall ist.

**12.** Verfahren nach Anspruch 1, wobei das Messen eines durchschnittlichen Stromverbrauchs ferner ein Auslösen des Simulators aufweist, um ein Sammeln von Strommessungsdatenpunkten (201) zu starten, wenn eine Sendeaktivität erfasst wird, und wobei das Auslösen ein Setzen eines Schwellenwertes für den Strompegel aufweist, der grösser als der Stromverbrauchspegel für den Nur-Empfänger-Betrieb ist.

**13.** Verfahren nach Anspruch 1, ferner mit Bestimmen einer Empfangskapazitätsverwendung, wobei das Bestimmen einer Empfangskapazitätsverwendung aufweist:

Konfigurieren des Basisstationsemulators, zeitgeberbasierte Registrierung und alle anderen Typen von Registrierungen außer der Leistung-an-Registrierung abzuschalten, und

Messen der Empfangsstromanordnung der Mobilstation Segment für Segment unter Verwendung eines Abtastintervalls, das klein genug ist, alle Stromaktivitäten zu erfassen.

**14.** Verfahren nach Anspruch 13, wobei das Bestimmen einer Empfangskapazitätsverwendung ferner aufweist:

Aufnehmen von Mehrfachempfangsstromsegmenten (226),
für jedes Segment:

Nachbearbeiten der Strommessungsdatenanordnung (228) und
Berechnen des Mittelwertstromwertes jedes Empfangssegments (230),

Berechnen des Mittelwertes ($i_{rx}$) über alle gemessenen Segmente (232)
und
Bestimmen der Kapazität, die während einer Stunde im Empfangsmodus des Mobilstationbetriebes (234) verwendet wird.

**15.** Verfahren nach Anspruch 14, wobei die Kapazität, die für eine Stunde im Empfangsmodus ($C_{rx\_in\_1hr}$) verwendet wird, berechnet wird durch:

$$C_{rx\_in\_1hr} = (i_{rx} * (1 - t_{tx\_in\_1hr}))$$

wobei

$$T_{tx\_in\_1hr} = \left( \sum_{j=1}^{N} (tj) \right) * (M / N);$$

$$t_j = m * \Delta t$$

m der letzte Punkt einer Sendeaktivität ist, und $\Delta t$ ein Abtastintervall ist,
die Gesamtkapazität, die von der Mobilstation verwendet ist,

$$C_{1hr} = C_{rx\_in\_1hr} + C_{tx\_in\_1hr};$$

Ist, und die Bereitschaftszeit in Stunden als

$$T_{standby} = (C_{new} - C_{cutoff})/(C_{1hr})$$

berechnet ist, wobei $C_{new}$ - $C_{cutoff}$ der Kapazitätsunterschied zwischen einer vollgeladenen Batterie und der Kapazität an einer Abschaltspannung ist.

**16.** Verfahren nach Anspruch 14, wobei die Kapazität, die für eine Stunde vom Empfangsmodus ($C_{rx\_in\_1hr}$) verwendet wird, berechnet wird durch:

$$C_{rx\_in\_1hr} = (i_{rx} * 1hr).$$

**17.** Verfahren nach Anspruch 1, ferner mit Bestimmen eines durchschnittlichen Empfangsstroms, wobei das Bestimmen eines durchschnittlichen Empfangsstroms aufweist:

Konfigurieren des Basisstationsemulators, zeitgeberbasierte Registrierung und alle anderen Typen von Registrierungen außer der Leistung-an-Registrierung abzuschalten, und
Messen der Empfangsstromanordnung der Mobilstation Segment für Segment unter Verwendung eines Abtastintervalls, das klein genug ist, alle Stromaktivitäten einzufangen.

**18.** Verfahren nach Anspruch 17, wobei das Bestimmen eines durchschnittlichen Empfangsstroms ferner aufweist:

Aufnehmen von Mehrfachempfangsstromsegmenten,
für jedes Segment:

Nachbearbeiten der Strommessungsdatenanordnung und
Berechnen des Mittelwertstromwertes jedes Empfangssegments
und

Berechnen des Mittelwertes ($i_{rx}$) über alle gemessenen Segmente.

**19.** Verfahren nach Anspruch 18, wobei die Bereitschaftszeit in Stunden als

$$T_{standby} = (C_{new} - C_{cutoff})/(i_{tx} + i_{rx})$$

berechnet wird, wobei $C_{new}$ - $C_{cutoff}$ der Kapazitätsunterschied zwischen einer vollgeladenen Batterie und der Kapazität an einer Abschaltspannung ist und $i_{tx} + i_{rx}$ die Summe des durchschnittlichen Sendestroms und des durchschnittlichen Empfangsstroms ist.

**20.** System zum Bestimmen einer Bereitschaftszeit für eine Mobilstation, wobei das System aufweist:

einen Batteriesimulator (18),
einen Basisstationsemulator (14) und
einen Computer (20) mit einem computerlesbaren Medium, das Programmcode speichert, der veranlasst, wenn er von einem Prozessor des Computers ausgeführt wird, dass das System das Verfahren nach einem der Ansprüche 1 bis 19 durchführt.

**21.** Computerlesbares Medium, das Programmcode speichert, der veranlasst, wenn er von einem Prozessor eines Computers ausgeführt wird, dass der Computer das Verfahren nach einem der Ansprüche 1 bis 19 durchführt.

**Revendications**

**1.** Procédé pour déterminer un temps de veille pour une station mobile (12), le procédé comprenant le fait :

de mesurer (102) une consommation moyenne de courant lorsque la station mobile est en mode attente, ledit mode attente comportant un mode transmission et un mode réception ; ladite consommation moyenne de courant étant mesurée à la fois en mode transmission et en mode réception ; la mesure de la consommation moyenne de courant comprenant le fait

de mesurer une première pluralité de points de données de mesure de courant dans un évènement de transmission dans le mode transmission, et

de mesurer une deuxième pluralité de points de données de mesure de courant dans un segment de réception dans le mode réception ;

de déterminer (114) une capacité disponible d'une batterie dans la station mobile ; et

de déterminer un temps de veille (104) pour la station mobile en fonction de la capacité disponible de la batterie et de la consommation moyenne de courant,

dans lequel la mesure de la consommation moyenne de courant est effectuée pendant une durée inférieure au temps de veille.

2. Procédé tel que revendiqué dans la revendication 1, dans lequel la deuxième pluralité de points de données de mesure de courant sont mesurés à une pluralité d'intervalles de mesure.

3. Procédé tel que revendiqué dans la revendication 1, dans lequel la mesure de la consommation moyenne de courant est effectuée à intervalles plus courts que les intervalles entre des modes transmission dans le mode veille dans un réseau en direct.

4. Procédé tel que revendiqué dans la revendication 1, dans lequel la capacité disponible de la batterie est déterminée sur la base d'une tension (40) de la batterie à l'extinction de la radio.

5. Procédé tel que revendiqué dans la revendication 1, comprenant en outre la détermination d'une tension de la batterie à la coupure de la radio, la capacité disponible de la batterie étant déterminée sur la base d'une tension (40) de la batterie à l'extinction de la radio.

6. Procédé tel que revendiqué dans la revendication 5, dans lequel la détermination d'une tension de la batterie à l'extinction de la radio comprend le fait :

de fournir (39) une tension simulée de la batterie à une première valeur de tension à la station mobile (12) ;
de déterminer si la radio de la station mobile est allumée (36) ;
de décrémenter (38) par une grandeur prédéterminée (38) la première valeur de tension à une prochaine valeur prédéterminée de tension, si la radio de la station mobile est allumée, et de répéter l'étape qui consiste à déterminer si la radio de la station mobile est allumée ;
d'enregistrer la tension de la batterie à l'extinction de la radio, si la radio de la station mobile est éteinte.

7. Procédé tel que revendiqué dans la revendication 6, dans lequel la détermination d'une tension de la batterie à l'extinction de la radio est répétée plusieurs fois et on établit la moyenne de la valeur de tension résultante en vue de déterminer la tension de la batterie à l'extinction de la radio.

8. Procédé tel que revendiqué dans la revendication 7, comprenant en outre la simulation de l'effet d'une résistance série équivalente, dit effet « ESR », de la batterie lors de la détermination de la tension de la batterie à l'extinction de la radio.

9. Procédé tel que revendiqué dans la revendication 1, comprenant en outre l'extraction des points de données de mesure de courant de la pluralité d'évènements de transmission relatifs au temps où le transmetteur est allumé (204).

10. Procédé tel que revendiqué dans la revendication 9, comprenant en outre le calcul de la capacité utilisée de chacune de la pluralité d'événements de transmission.

11. Procédé tel que revendiqué dans la revendication 10, comprenant en outre le calcul d'une utilisation de capacité moyenne ($c_{tx}$) dans chacun de la pluralité d'événements de transmission selon :

$$\mathrm{C_{tx}} = (\sum\nolimits_{j=1}^{N} (Cj))/N,$$

où N est un nombre total d'événements de transmission mesurés ; et
le calcul du courant de transmission moyen ($i_{tx}$) par :

$$i_{tx} = C_{tx}/T_{tx}$$

où $T_{tx}$ est un intervalle d'enregistrement.

12. Procédé tel que revendiqué dans la revendication 1, dans lequel la mesure de la consommation moyenne de courant comprend en outre le fait de déclencher le simulateur pour commencer à collecter des points de données de mesure de courant (201) lorsqu'une activité de transmission est détectée et dans lequel le déclenchement comprend le fait de fixer un seuil pour un niveau d'intensité de courant supérieur au niveau de consommation de courant pour le fonctionnement du récepteur uniquement.

13. Procédé tel que revendiqué dans la revendication 1, comprenant en outre le fait de déterminer une utilisation de capacité de réception, la détermination d'une utilisation de capacité de réception comprenant le fait :

de configurer l'émulateur de station de base pour désactiver un enregistrement basé sur une minuterie et tous les autres types d'enregistrements à l'exception de l'enregistrement de mise sous tension ; et
de mesurer l'ensemble de courants de réception de la station mobile segment par segment en utilisant un intervalle d'échantillonnage assez petit pour capturer toutes les activités en cours.

14. Procédé tel que revendiqué dans la revendication 13, dans lequel la détermination d'une utilisation de capacité de réception comprend le fait :

d'enregistrer (226) plusieurs segments de courant de réception;
pour chaque segment :

de post-traiter (228) l'ensemble de données de mesure de courant; et
de calculer (230) la valeur moyenne de courant pour chaque segment de réception;
de calculer (232) la moyenne ($i_{rx}$) sur tous les segments mesurés; et
de déterminer (234) la capacité utilisée en étant en mode réception pendant une heure du fonctionnement de la station mobile.

15. Procédé tel que revendiqué dans la revendication 14, dans lequel la capacité ($C_{rx\_in\_1hr}$) utilisée pendant une heure par un mode réception est calculée suivant :

$$C_{rx\_in\_1hr} = (i_{rx} * (1-t_{tx\_in\_1hr}))$$

où

$$t_{tx\_in\_1hr} = (\sum_{j=1}^{N}(tj)) * (M/N);$$

$$t_j = m * \Delta t;$$

m est le dernier point d'une activité de transmission;
et
$\Delta t$ est un intervalle d'échantillonnage;
la capacité totale utilisée par la station mobile pendant une heure est :

$$C_{1hr} = C_{rx\_in\_1hr} + C_{tx\_in\_1hr};$$

et le temps de veille en heures est calculé suivant :

$$\mathrm{T}_{standby} = (\mathrm{C}_{new} - \mathrm{C}_{cutoff}) / (\mathrm{C}_{1hr})$$

où $C_{new}$ - $C_{cutoff}$ est la différence de capacité entre une batterie complètement chargée et la capacité à la tension d'extinction.

16. Procédé tel que revendiqué dans la revendication 14, la capacité utilisée pendant une heure par le mode réception ($C_{rx\_in-1hr}$) est calculée par :

$$\mathrm{C}_{rx\_in\_1hr} = (\mathrm{i}_{rx} * 1hr).$$

17. Procédé tel que revendiqué dans la revendication 1, comprenant en outre la détermination d'un courant de réception moyen, la détermination d'un courant de réception moyen comprenant le fait :

de configurer l'émulateur de station de base pour désactiver un enregistrement basé sur une minuterie et tous les autres types d'enregistrements à l'exception de l'enregistrement de mise sous tension ; et
de mesurer l'ensemble de courants de réception de la station mobile segment par segment en utilisant un intervalle d'échantillonnage assez petit pour capturer toutes les activités en cours.

18. Procédé tel que revendiqué dans la revendication 17, dans lequel la détermination d'un courant de réception moyen comprend en outre le fait :

d'enregistrer plusieurs segments de courant de réception ;
pour chaque segment :

de post-traiter l'ensemble de données de mesure de courant ; et
de calculer la valeur de courant moyenne pour chaque segment de réception ; et
de calculer la moyenne ($i_{rx}$) sur tous les segments mesurés.

19. Procédé tel que revendiqué dans la revendication 18, dans lequel le temps de veille en heures est calculé pour être :

$$\mathrm{T}_{standby} = (\mathrm{C}_{new} - \mathrm{C}_{cutoff}) / (\mathrm{i}_{tx} + \mathrm{i}_{rx})$$

où $C_{new}$ - $C_{cutoff}$ est la différence de capacité entre une batterie complètement chargée et la capacité à la tension d'extinction, et $i_{tx}$ + $i_{rx}$ est le total du courant de transmission moyen et du courant de réception moyen.

20. Système pour déterminer un temps de veille pour une station mobile, le système comprenant :

un simulateur de batterie (18) ;
un émulateur de station de base (14) ; et
un ordinateur (20) comprenant un support lisible par ordinateur stockant un code de programme qui lorsqu'il est exécuté par un processeur dudit ordinateur amène le système à mettre en oeuvre le procédé de l'une quelconque des revendications 1 à 19.

21. Support lisible par ordinateur stockant un code de programme qui lorsqu'il est exécuté par un processeur d'un ordinateur amène l'ordinateur à mettre en oeuvre le procédé de l'une quelconque des revendications 1 à 19.

Fig. 1

EP 1 748 663 B1

Fig. 2

Fig. 3

EP 1 748 663 B1

Current (A)

Data Points

**Fig. 4**

100

| Determine available capacity of battery | Measure average current consumption |
|---|---|

114                                102

| Calculate the standby time of the MSUT |
|---|

104

**Fig. 5**

110

| Determine the battery shut off voltage |
|---|

112

| Determine available capacity of battery | Measure average current consumption |
|---|---|

114                                102

| Calculate the standby time of the MSUT |
|---|

104

**Fig. 6**

120

| Measure receive current | Measure transmit current |
|---|---|

124    122

102

Determine available capacity of battery

114

Calculate the standby time of the MSUT

104

Fig. 7

EP 1 748 663 B1

```
                                        ┌─ 112
┌──────────────────────────┐
│  Determine the battery shut off  │
│           voltage               │
└──────────────────────────┘                    130
         │        ┊ V_cutoff  ┌─ 114
         ▼        ▼
┌──────────────────────────┐          C_new - C_cutoff
│   Determine the available   │ ⋯⋯⋯⋯⋯⋯⋯⋯⋯⋯⋯⋯⋯
│    capacity of the battery   │                              ┌─ 104
└──────────────────────────┘                        ┌──────────────────────────┐
         │                                           │ Calculate the standby time of the │
         ▼             ┌─ 122          C_tx_in_1hr    │            MSUT              │
┌──────────────────────────┐ ⋯⋯⋯⋯⋯⋯⋯⋯⋯⋯⋯⋯> └──────────────────────────┘
│   Measure transmit current  │
└──────────────────────────┘
         │   ┊ t_tx_in_1hr  ┌─ 124
         ▼   ▼                        C_rx_in_1hr
┌──────────────────────────┐ ⋯⋯⋯⋯⋯⋯⋯⋯⋯⋯⋯⋯
│   Measure receive current   │
└──────────────────────────┘       ┌─ 102
```

# Fig. 8

Fig. 9

EP 1 748 663 B1

**Fig. 10**

30

32
33 — Set ESR
35 — Set base station emulator
37 — Wait for MSUT to enter slotted mode
39 — Set initial value of battery simulator

34 — Wait for Battery Voltage Update

36 — Radio ON?

NO

YES

38 — Decrement Battery Voltage

40 — Record Voltage Level

42 — Turn Radio Back On, Go to Step 34 N times, Otherwise end

122

```
┌─────────────────────────────────────────────────────────────────┐
│   Collect a sufficient time span of current measurement data points │
└─────────────────────────────────────────────────────────────────┘
                                    │           202
                                    ▼
┌─────────────────────────────────────────────────────────────────┐
│  Extract the measurements relating to the time the transmitter is turned on │
└─────────────────────────────────────────────────────────────────┘
                                    │           204
                                    ▼
┌─────────────────────────────────────────────────────────────────┐
│        Calculate the capacity used $(C_j)$ of each transmit event        │
└─────────────────────────────────────────────────────────────────┘
                                                206
```

Fig. 11

123

```
┌─────────────────────────────────────────────────────────┐
│                      Repeat N times                      │
└─────────────────────────────────────────────────────────┘
                            │
                            ▼
┌─────────────────────────────────────────────────────────┐
│  Trigger the simulator to start collecting current      │
│  measurement data points when a transmit activity is    │
│  detected                                               │
└─────────────────────────────────────────────────────────┘
                                          201
                            │
                            ▼
┌─────────────────────────────────────────────────────────┐
│  Collect a sufficient time span of current measurement  │
│  data points                                            │
└─────────────────────────────────────────────────────────┘
                                          202
                            │
                            ▼
┌─────────────────────────────────────────────────────────┐
│  Extract the measurements relating to the time the      │
│  transmitter is turned on                               │
└─────────────────────────────────────────────────────────┘
                                          204
                            │
                            ▼
┌─────────────────────────────────────────────────────────┐
│                     Next iteration                      │
└─────────────────────────────────────────────────────────┘
                            │
                            ▼
┌─────────────────────────────────────────────────────────┐
│  Calculate the capacity used ($C_j$) and time duration  │
│  ($t_j$) of each transmit event,                        │
└─────────────────────────────────────────────────────────┘
                                          207
                            │
                            ▼
┌─────────────────────────────────────────────────────────┐
│  Determine the average capacity used by transmit        │
│  events in one hour and the time spent in transmitting  │
│  events during one hour                                 │
└─────────────────────────────────────────────────────────┘
                                          208
```

## Fig. 12

EP 1 748 663 B1

— 124

```
┌─────────────────────────────────────────────────────────────────────┐
│ Configuring the base station emulator to disable timer based registration and │
│        all other types registrations except the power up registration │
└─────────────────────────────────────────────────────────────────────┘
```

— 222

```
┌─────────────────────────────────────────────────────────────────────┐
│ Measure the receive current array of the MSUT segment by segment using a │
│        sampling interval small enough to capture all current activities │
└─────────────────────────────────────────────────────────────────────┘
```

— 224

Fig. 13

125

┌─────────────────────────────────────────────────────────────────┐
│ Configuring the base station emulator to disable timer based registration and │
│ all other types registrations except the power up registration │
└─────────────────────────────────────────────────────────────────┘
                                                          222

┌─────────────────────────────────────────────────────────────────┐
│ Measure the receive current array of the MSUT segment by segment using a │
│ sampling interval small enough to capture all current activities │
└─────────────────────────────────────────────────────────────────┘
                                                          224

┌─────────────────────────────────────────────────────────────────┐
│                  Record multiple receive current segments                  │
└─────────────────────────────────────────────────────────────────┘
                                                          226

┌─────────────────────────────────────────────────────────────────┐
│                          For each segment                          │
└─────────────────────────────────────────────────────────────────┘

┌─────────────────────────────────────────────────────────────┐
│              Post process the current measurement data array              │
└─────────────────────────────────────────────────────────────┘
                                                          228

┌─────────────────────────────────────────────────────────────┐
│          Calculate the mean current value of each receive segment          │
└─────────────────────────────────────────────────────────────┘
                                                          230

┌─────────────────────────────────────────────────────────────────┐
│                           Next segment                            │
└─────────────────────────────────────────────────────────────────┘

┌─────────────────────────────────────────────────────────────┐
│            Calculate the mean over all the segments measured            │
└─────────────────────────────────────────────────────────────┘
                                                          232

┌─────────────────────────────────────────────────────────────────┐
│ Determine the capacity used while in receive mode for 1 hour of MSUT │
│ operation │
└─────────────────────────────────────────────────────────────────┘
                                                          234

Fig. 14

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **Edward Brorein.** Using Battery Drain Analysis to Improve Mobile Device Operating Time. *Agilent Technologies,* 2002